# EUROPEAN PATENT APPLICATION

(11) **EP 4 590 085 A1**
(43) Date of publication of application: **23.07.2025**
(21) Application number: 25150628.3
(22) Date of filing: 08.01.2025
(51) Int. Cl.: H10D 30/01, H10D 30/47, H10D 62/17, H10D 64/27, H10D 84/84, H10D 62/85, H10D 64/23

(54) **IMPROVED DEPLETION MODE HEMT DEVICE AND MANUFACTURING PROCESS THEREOF**

(30) Priority: 22.01.2024 IT 202400001065
(71) Applicant: STMicroelectronics International N.V., 1228 Plan-les-Ouates, Geneva (CH)
(72) Inventor: MICCOLI, Cristina, 95030 TREMESTIERI ETNEO (CT) (IT); CASTAGNA, Maria Eloisa, 95123 CATANIA (IT); MARCHESI, Marco, 20011 CORBETTA (MI) (IT); TRINGALI, Cristina, 96011 AUGUSTA (SR) (IT); IUCOLANO, Ferdinando, 95030 GRAVINA DI CATANIA (CT) (IT)
(74) Representative: Studio Torta S.p.A.

(57) **Abstract**

HEMT device (50) comprising: a heterostructure (62) comprising a channel layer (64) and a barrier layer (66) extending, along a first axis (Z), onto the channel layer (64); a dielectric protection layer (67) of dielectric material, extending along the first axis (Z) onto the barrier layer (66); and a gate region (74) extending along the first axis (Z) onto the dielectric protection layer (67), wherein the dielectric protection layer (67) has, along the first axis (Z), a thickness (t_{d}) lower than 10 nm.

## Description

### TECHNICAL FIELD

The present invention relates to an improved High Electron Mobility Transistor (HEMT) device, in particular a depletion mode device, and to a manufacturing process thereof. Furthermore, it relates to an electronic assembly comprising the HEMT device.

### STATE OF THE ART

HEMT devices are known in which a conductive channel is based on the formation of layers of two-dimensional electron gas (2DEG) with high mobility at a heterostructure, i.e. at the interface between semiconductor materials with different band gaps. For example, HEMT devices are known based on the heterostructure between an aluminum gallium nitride (AlGaN) barrier layer and a gallium nitride (GaN) channel layer.

HEMT devices based on AlGaN/GaN heterostructures offer various advantages that make them particularly suitable and widely used for different applications. For example, the high breakdown threshold of HEMT devices is exploited for high-performance power switches; the high mobility of the electrons in the conductive channel allows high-frequency amplifiers to be manufactured; furthermore, the high concentration of electrons in the 2DEG allows a low ON-state resistance (R_{ON}) to be obtained. Furthermore, HEMT devices for radio frequency (RF) applications typically have better RF performance compared to similar silicon devices.

Normally GaN/AlGaN HEMTs operate in depletion mode, (also referred to as "D-mode") and are therefore normally-on. In detail, in D-mode HEMTs the gate structure placed over the barrier layer is biased to a negative gate voltage as regards the drain and the source biases, in order to deplete the 2DEG.

In greater detail, two solutions are commonly known for manufacturing D-mode HEMTs: with a gate structure that forms a Schottky-type contact with the barrier layer, or with an insulated-type gate structure. In the first case, the gate structure has a metal gate region (e.g., of Ni-Au or Pt) which is in contact with the barrier layer and therefore forms a Schottky-type contact with the latter. In the second case, the gate structure has a metal gate region and a gate insulating layer (e.g., of SiO₂) interposed between the metal gate region and the barrier layer, to block the generation of the gate current. The thickness of the gate insulating layer is higher than 10 nm and is usually equal to about 20 nm. This allows a negative "pinch-off" voltage to be obtained for gate voltage values lower than about -10 V, thus avoiding the HEMT device to switch off in operating conditions of high drain voltages (e.g., voltages up to 650 V).

However, several practical applications also require GaN/AlGaN HEMTs that operate in enhancement mode (also referred to as "E-mode") and are therefore normally-off. These devices allow safe operation and driving circuit simplification to be ensured.

Different approaches are known to obtain normally-off HEMTs, such as using a p-GaN-type gate structure, of a recess-type or with fluorine plasma incorporation under the metal gate region. In particular, the pGaN-type gate structure is the one that is normally most used in the products currently available on the market, given its superior electrical performance and its greater ease of manufacturing with respect to the other above-mentioned solutions.

In detail, pGaN-type HEMTs have a gate structure that comprises a metal gate region and a channel modulation region which is of pGaN (gallium nitride with P-type conductivity due for example to doping with magnesium) and extends between the metal gate region and the barrier layer. As is known, the presence of the channel modulation region alters the band diagram of the HEMT and makes it of normally-off type.

However, there are currently no known solutions that allow both D-mode HEMTs and E-mode HEMTs of pGaN-gate-type to be manufactured in an integrated manner, while maintaining high electrical performance of these devices. As a result, it is currently not possible in practice to have both these types of devices on a monolithic and small-sized support.

In fact, it has been verified that the known solutions that attempt to integrate the E-mode HEMTs of pGaN-gate-type with the D-mode HEMTs with the Schottky-type gate structure have D-mode HEMTs with highly degraded electrical performance. This is due to the fact that during the step of forming the gate structure of the D-mode HEMT, an etching of the oxide overlying the barrier layer is required, which needs to be removed at the zone in which it is desired to form the gate structure in order to locally expose the barrier layer so that the Schottky contact may be formed. This etching damages the upper surface of the barrier layer, intended to be in contact with the metal gate region. In particular, the etching introduces traps in the barrier layer for the charge carriers and this causes instability of the gate voltage and a higher on-state resistance. In more detail, damage to the barrier layer causes a leakage current of the reverse-biased Schottky junction and makes the pinch-off voltage quite sensitive to various manufacturing process factors.

Instead, it is known that there are currently no solutions available that allow both the E-mode HEMTs of pGaN-gate-type and the D-mode HEMTs with the insulated-type gate structure to be integrated into a same manufacturing process, in particular if for high-power applications (i.e. with drain voltage that may reach 650 V). In fact, the high thickness required for the gate insulating layer of the D-mode HEMTs makes the manufacturing of these D-mode HEMTs incompatible with the manufacturing process flow of E-mode HEMTs of pGaN-gate-type. Currently, the D-mode HEMTs with the insulated-type gate structure are manufactured separately from the E-mode HEMTs of pGaN-gate-type and these two types of HEMTs are then assembled afterwards on a single support. As a result, their manufacturing is not integrated, and the result is not a monolithic solution.

Document US 2017/294530 A1 relates to electronic devices and more particularly to electronic devices including high-electron mobility transistors including segmented gate electrodes.

Document US 2014/239346 A1 relates to electronic devices and more particularly to MISHFET and HFET or other Schottky structures based on GaN.

Document Zhang Yujian et al., "On-chip AlGaN/GaN HEMTs with the Compatible Normally-off p-GaN Gate and Normally-on MIS Gate Fabrication Processes", IEEE, 25 October 2022 relates to an on-chip normally-off/on AlGaN/GaN HEMTs, using p-GaN gate, with the compatible fabrication processes.

Document US 11 799 000 B1 relates to a high electron mobility transistor (HEMT) and a high electron mobility transistor forming method, specifically to an enhancement mode of a high electron mobility transistor and a method forming the same.

The aim of the present invention is to provide a HEMT device, a manufacturing process thereof and an electronic assembly comprising the HEMT device, which overcome the drawbacks of the prior art.

### SUMMARY OF THE INVENTION

According to the present invention, a HEMT device, a manufacturing process thereof and an electronic assembly comprising the HEMT device are provided, as defined in the annexed claims which form an integral part of the present description.

### BRIEF DESCRIPTION OF THE DRAWINGS

For a better understanding of the present invention, a preferred embodiment is now described, purely by way of nonlimiting example, with reference to the attached drawings, wherein:
- Figure 1 shows a cross-section of the present HEMT device, according to one embodiment;
- Figures 2A-2J show cross-sections of the HEMT device of Figure 1, in subsequent manufacturing steps;
- Figures 3A-3C show cross-sections of a further HEMT device integrable with the HEMT device of Figure 1, in subsequent manufacturing steps; and
- Figure 4 shows a cross-section of an electronic assembly comprising the HEMT device of Figure 1 and the further HEMT device of Figure 3C, according to one embodiment.

In particular, the Figures are shown with reference to a triaxial Cartesian system defined by an X axis, a Y axis and a Z axis, orthogonal to each other.

In the following description, elements common to the different embodiments have been indicated with the same reference numbers.

### DETAILED DESCRIPTION OF THE INVENTION

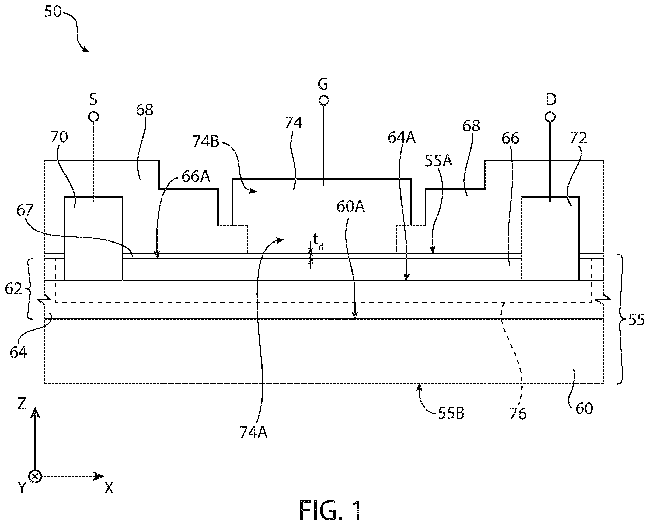

Figure 1 shows a HEMT device (also referred to as first HEMT device) 50, in particular a normally-on and therefore depletion, "D-mode", HEMT device.

The HEMT device 50 is in particular for being used in RF applications, such as for example 4G and 5G base stations, including evolutions and variants of the technology, portable telephones, RF cooking devices, drying and heating devices, devices and systems for avionics, L- and S-band radar, and the like.

The HEMT device 50 is formed into a body 55 having a first surface 55A and a second surface 55B and comprising a substrate 60, a heterostructure 62 extending over the substrate 60, and a dielectric protection layer 67 extending over the heterostructure 62.

The substrate 60, of semiconductor material, for example silicon or silicon carbide, sapphire (Al₂O₃) or other materials, extends between the second surface 55B of the body 55 and a respective surface 60A opposite to the first surface 55A along the Z axis.

The heterostructure 62 comprises compound semiconductor materials including elements of group III-V and extends onto the surface 60A of the substrate 60.

The heterostructure 62 is formed by a channel layer 64 of a first semiconductor material, for example gallium nitride (GaN) or a ternary alloy based on gallium nitride such as InGaN (here it is of intrinsic gallium nitride), extending onto the substrate 60 and having a surface 64A opposite to the surface 60A along the Z axis, and by a barrier layer 66 of a second semiconductor material, for example a ternary or quaternary alloy based on gallium nitride, such as AlₓGa₁₋ₓN, AlInGaN, InₓGa₁₋ₓN, AlₓIn₁₋ₓAl, AlScN (here it is of intrinsic gallium aluminum nitride, AlGaN), extending between the surface 64A of channel layer 64 and a surface 66A opposite to the surface 64A along the Z axis.

According to an embodiment not shown, the HEMT device 50 may further comprise, between the substrate 60 and the heterostructure 62, a nucleation layer and a buffer layer extending over the nucleation layer. In particular, the nucleation layer is of a material that allows the nucleation of the channel layer 64 on the substrate 60, reducing the lattice mismatch between the channel layer 64 and the substrate 60. For example, the nucleation layer is of aluminum nitride (AlN). Furthermore, the buffer layer is of a material that reduces the drain current for zero bias IDSS of the HEMT device 50, for example it is of GaN doped with carbon atoms.

The dielectric protection layer 67 extends onto the surface 66A of the barrier layer 66 and forms the first surface 55A of the body 55.

The dielectric protection layer 67 is of dielectric material such as aluminum oxide (Al₂O₃), silicon oxide (SiO₂), silicon nitride (Si₃N₄) and aluminum nitride (AlN).

The dielectric protection layer 67 has a thickness t_{d}, measured along the Z axis, lower than 10 nm and in particular comprised between about 1 nm and about 7 nm (boundary values included).

As better described hereinbelow, the dielectric protection layer 67 allows, during the manufacturing of the HEMT device 50, the barrier layer 66 to be protected, avoiding the formation of traps for charge carriers in the latter which degrade the electrical performance of the HEMT device 50.

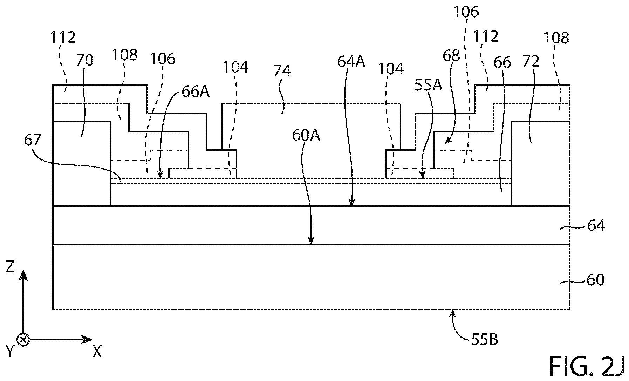

The HEMT device 50 may further comprise a passivation layer 68, of dielectric material or formed by a stack of dielectric materials (such as for example silicon nitride and silicon oxide) and extending onto the first surface 55A of the body 55. In the example of Figure 1 there is exemplarily shown the case in which the passivation layer 68b is formed by a single layer of dielectric material, nevertheless it is similarly possible to have a more complex structure of the passivation layer 68 (as for example shown in Figure 2J).

The HEMT device 50 further comprises a source region 70 and a drain region 72, extending in direct electrical contact with the heterostructure 62, and a gate region 74, extending between the source region 70 and the drain region 72 and on the dielectric protection layer 67 in such a way as to be physically insulated from the heterostructure 62 and to be electrically coupled to the latter through physical phenomena such as the tunnel effect.

The body 55 accommodates an active region 76, indicated by a dashed line in Figure 1, which accommodates in use a conductive channel of the HEMT device 50.

The source region 70 and the drain region 72 are of conductive material, for example metal material, and extend in depth into the body 55, completely through the dielectric protection layer 67 and the barrier layer 66 and up to the surface 64A of the channel layer 64.

In practice, the source region 70 and the drain region 72 respectively form a source electrode S and a drain electrode D of the HEMT device 50.

In detail, the source region 70 and the drain region 72 form an ohmic contact with the heterostructure 62, in particular with the channel layer 64.

According to a different embodiment, not illustrated here, the source region 70 and the drain region 72 may extend only partially through the barrier layer 66, and end within the barrier layer 66.

According to a different embodiment, not illustrated here, the source region 70 and the drain region 72 may extend only through the insulating layer 68 and the dielectric protection layer 67, up to reaching the surface 66A of the barrier layer 66 and therefore without extending in depth into the barrier layer 66.

According to a further embodiment, not illustrated here, the source region 70 and the drain region 72 may also extend partially through the channel layer 64, and end in the channel layer 64.

Furthermore, the source region 70 and the drain region 72 may extend to depths different from each other into the body 55.

In practice, depending on the specific application of the HEMT device 50 and the specific manufacturing process used to obtain the source region 70 and the drain region 72, the source region 70 and the drain region 72 may be in direct ohmic contact with the channel layer 64 or may be in electrical contact with the channel layer 64 due to different physical phenomena, for example due to the tunnel effect.

The gate region 74 is of conductive material, for example metal material, and may be formed by a single conductive layer or by a stack of conductive layers, comprising for example gold, nickel, titanium, etc., depending on the specific application.

The dielectric protection layer 67 is directly interposed along the Z axis between the barrier layer 66 and the gate region 74. In other words, the dielectric protection layer 67 extends into contact with both the barrier layer 66 and the gate region 74.

The gate region 74 forms a gate electrode G of the HEMT device 50.

The gate region 74 is physically insulated with respect to the heterostructure 62, in particular due to the dielectric protection layer 67. In other words, the gate region 74 and the portion of the dielectric protection layer 67 vertically aligned (i.e. aligned along the Z axis) to the gate region 74 together form an insulated-type gate structure of the HEMT device 50. However, there may be tunneling phenomena between the gate region 74 and the heterostructure 62, which make the gate region 74 electrically coupled to the heterostructure 62.

In detail, the dielectric protection layer 67 extends uniformly between the barrier layer 66 and the passivation layer 68 or the gate region 74. Alternatively, the dielectric protection layer 67 may extend locally between the barrier layer 66 and the gate region 74, therefore it may not extend under the passivation layer 68. Nonetheless, at least at the gate region 74 the dielectric protection layer 67 is present.

For example, the gate region 74 may comprise a surface portion 74A and an upper portion 74B, which are contiguous to each other. The surface portion 74A extends onto the dielectric protection layer 67 and through the passivation layer 68, while the upper portion 74B extends onto the surface portion 74A and partially over the passivation layer 68.

In detail, the passivation layer 68 extends on both the drain region 72 and the source region 70, for example leaving the gate region 74 partially exposed.

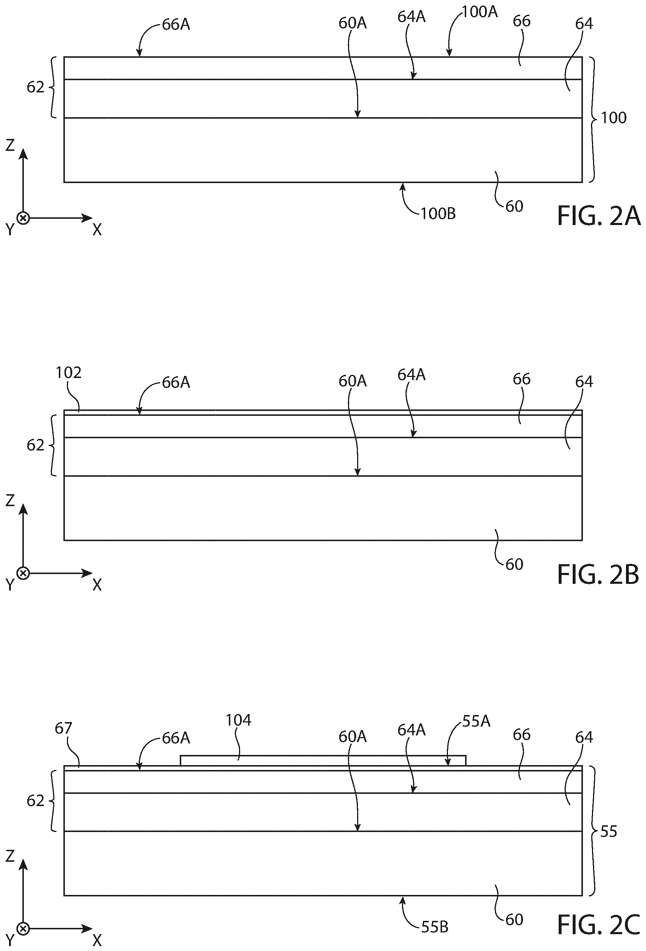

Hereinbelow, with reference to Figures 2A-2J, manufacturing steps of the HEMT device 50 are described, in particular the manufacturing steps that lead to the formation of the gate region 74 superimposed on the dielectric protection layer 67.

Figures 2A-2J are focused on the manufacturing of the gate region 74 superimposed on the dielectric protection layer 67 and do not illustrate known (concurrent, previous and/or subsequent) steps for forming other components of the HEMT device 50, such as electrical contact metallizations, generic electrical connections and any other element, known per se and not shown here, useful or necessary for the operation of the HEMT device 50.

Figure 2A shows a cross-section of a work body 100 having a first surface 100A (corresponding to the surface 66a of Figure 1) and a second surface 100B opposite to each other along the Z axis, during a manufacturing step of the HEMT device 50. Elements of the work body 100 common to what has already been described with reference to Figure 1, and shown in Figure 1, are indicated with the same reference numbers and are not further described in detail as their manufacturing is per se known.

In the work body 100, the substrate 60 and the heterostructure 62 comprising the channel layer 64 and the barrier layer 66 have already been formed.

Subsequently, Figure 2B, a dielectric layer 102 of dielectric material (such as Al₂O₃, SiO₂, Si₃N₄, AlN) is formed on the first surface 100A of the work body 100.

The dielectric layer 102 has a thickness, along the Z axis, lower than 10 nm and in particular comprised between about 1 nm and about 7 nm (boundary values included), and is formed for example by Atomic Layer Deposition (ALD). For example, water-based ALD is used, performed at about 300°C (thermally or through plasma).

At the end of the manufacturing steps, the dielectric layer 102 will form the dielectric protection layer 67 of the HEMT device 50 of Figure 1.

In particular, in the embodiment of Figure 1 the dielectric layer 102 formed as described herein already defines the dielectric protection layer 67, while for other embodiments of the HEMT device 50 other manufacturing steps may be envisaged to obtain the dielectric protection layer 67 starting from the dielectric layer 102.

For example, in case the dielectric protection layer 67 extends only under the gate region 74, the formation of the dielectric layer 102 described with reference to Figure 2B is followed by an etching that selectively removes the portions of the dielectric layer 102 that are intended to be vertically misaligned with the gate region 74, leaving instead the portion of the dielectric layer 102 which is intended to be vertically aligned with the gate region 74 and which forms the dielectric protection layer 67.

With reference again to the HEMT device 50 according to the embodiment described in detail herein, at the end of the step of Figure 2B the dielectric protection layer 67 is formed. As a result, the subsequent Figures show the dielectric protection layer 67 instead of the dielectric layer 102. As already described, the dielectric protection layer 67 forms the body 55 together with the heterostructure 62 and the substrate 60.

Subsequently, Figure 2C, a first insulating layer 104 of insulating material, such as silicon oxide, is formed on the dielectric protection layer 67 (i.e. on the first surface 55A of the body 55).

In detail, the first insulating layer 104 is formed at where the gate region 74 of the HEMT device 50 of Figure 1 will be formed. In greater detail, the first insulating layer 104 is selectively formed where the gate region 74 will subsequently be formed and laterally, along the x axis, to where the gate region 74 will be formed (for example, for a few micrometers or tenths of micrometer, e.g. 0.4 µm, starting from the gate region 74, on both sides of the latter). At the end of the manufacturing steps, the first insulating layer 104 will form part of the passivation layer 68 of the HEMT device 50 of Figure 1.

The first insulating layer 104 has a thickness comprised between about 20 nm and about 100 nm, for example equal to 50 nm, and is formed by Chemical Vapor Deposition (CVD), for example based on plasma (e.g., SiH₄ plasma), which is performed to uniformly deposit an oxide layer on the dielectric protection layer 67 and which is followed by a chemical etching (for example based on CF₄) on the deposited layer in order to leave the portion of the deposited layer which forms the first insulating layer 104, instead selectively removing the remaining portions of the deposited layer.

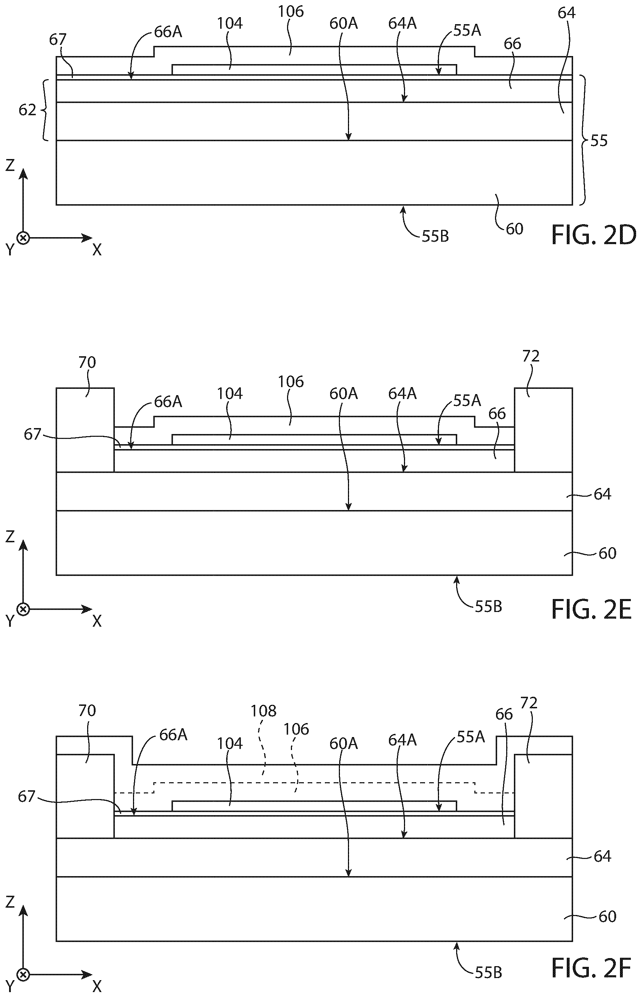

Subsequently, Figure 2D, a second insulating layer 106 of passivating material, such as silicon nitride, may be formed on the first insulating layer 104 and on the regions of the dielectric protection layer 67 exposed by the first insulating layer 104. However, this second insulating layer 106 is optional and may be absent in a different embodiment of the HEMT device 50.

The second insulating layer 106 has a thickness along the Z axis comprised between about 40 nm and about 150 nm and for example equal to about 80 nm, and is formed for example by CVD performed to deposit the second insulating layer 106 in a uniform manner where previously described.

At the end of the manufacturing steps, the second insulating layer 106 will form part of the passivation layer 68 of the HEMT device 50 of Figure 1.

Subsequently, Figure 2E, the source region 70 and the drain region 72 are formed.

In particular and in a manner not shown since it is known per se, one or more chemical etchings are performed (e.g. based on BCl₃ or ALE process) to create respective trenches for the source region 70 and the drain region 72. The trenches are formed through the second insulating layer 106, the dielectric protection layer 67 and the barrier layer 66, at where the source region 70 and the drain region 72 will be formed, respectively. For example, this etching step is performed using a mask which exposes the regions of the second insulating layer 106 where the source region 70 and the drain region 72 will be formed respectively and which, after the etching step, is removed. Thereafter, the source region 70 and the drain region 72 are formed in the respective trenches, for example through: formation of a mask that exposes the trenches covering the remaining parts of the second insulating layer 106; metal deposition in the trenches and on the mask (e.g., of a Ti/AlCu/TiN stack); removal of the mask and the metal deposition present thereon; thermal annealing (for example at about 560°C).

Subsequently, Figure 2F, a third insulating layer 108 of passivating material, such as silicon nitride, may be formed on the second insulating layer 106 and on the source region 70 and on the drain region 72.

The third insulating layer 108 has a thickness along the Z axis comprised between about 40 nm and about 150 nm and for example equal to about 80 nm, and is formed for example by CVD performed to deposit the third insulating layer 108 in a uniform manner where previously described.

At the end of the manufacturing steps, the third insulating layer 108 will form part of the passivation layer 68 of the HEMT device 50 of Figure 1.

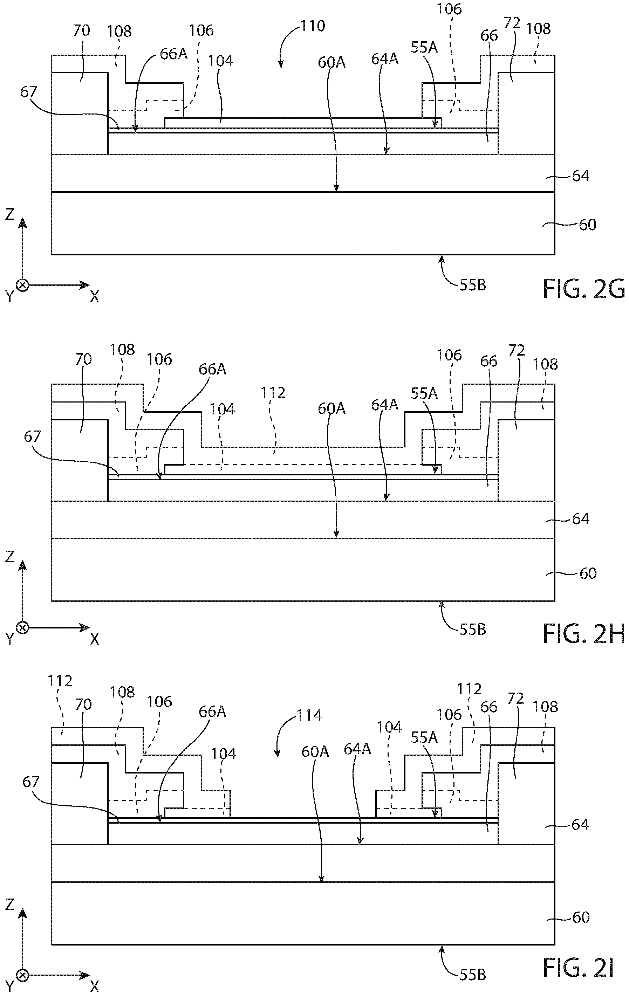

Subsequently, Figure 2G, a work window (or opening) 110 is formed through the second insulating layer 106 and the third insulating layer 108, in such a way as to expose the first insulating layer 104. For example, the first insulating layer 104 is exposed only partially, i.e. parts of the second insulating layer 106 and the third insulating layer 108 may remain on the first insulating layer 104 at its extremal portions along the X axis. The work window 110 is formed at where the gate region 74 will be formed, in particular it is formed where the gate region 74 will be formed and in zones lateral to the gate region 74 along the X axis.

The work window 110 is formed by selective chemical etching of the second insulating layer 106 and the third insulating layer 108, in such a way as to expose the first insulating layer 104 without etching it. For example, the chemical etching may be based on BCl₃ or through ALE process and is performed using a mask which exposes the region of the second insulating layer 106 where the work window 110 will be formed and which, after the etching step, is removed.

Subsequently, Figure 2H, a fourth insulating layer 112 of insulating material, such as tetraethyl orthosilicate (TEOS), is formed on the third insulating layer 108 and on the first insulating layer 104 exposed by the work window 110.

The fourth insulating layer 112 has a thickness along the Z axis comprised between about 80 nm and about 350 nm and for example equal to about 150 nm, and is formed for example by CVD performed to deposit the fourth insulating layer 112 in a uniform manner where previously described.

At the end of the manufacturing steps, the fourth insulating layer 112 will form part of the passivation layer 68 of the HEMT device 50 of Figure 1.

Subsequently, Figure 21, a gate window (or opening) 114 is formed through the fourth insulating layer 112 and the first insulating layer 104, in such a way as to expose the dielectric protection layer 67 at where the gate region 74 will be formed. For example, the gate window 114 has, along the X axis, a smaller width than the width of the work window 110 previously described, so that portions of the fourth insulating layer 112 and the first insulating layer 104 may remain alongside the gate region 74, when formed.

The gate window 114 is formed through a selective chemical etching step of the fourth insulating layer 112 and the first insulating layer 104, in such a way as to expose the dielectric protection layer 67 without etching it and therefore without exposing the underlying barrier layer 66. For example, considering the case in which the fourth insulating layer 112 and the first insulating layer 104 are of the same material and therefore only one chemical etching is sufficient in this step, this chemical etching may be based on a fluorinated solvent or in any case based on a chemical solvent configured to etch the material of the fourth insulating layer 112 and the first insulating layer 104 without etching the material of the dielectric protection layer 67. For example, the chemical etching is performed using a mask that exposes the region of the fourth insulating layer 112 where the gate region 74 will be formed and which, after the etching step, is removed.

Subsequently, Figure 2J, the gate region 74 is formed on the dielectric protection layer 67, in the gate window 114.

In particular, a mask is formed that exposes the gate window 114 (and possibly also regions of the fourth insulating layer 112 that are contiguous to the gate window 114), covering the remaining parts of the fourth insulating layer 112, then a metal deposition (e.g., of a Ti/AlCu/TiN stack) is performed on the mask and in the gate window 114 (and possibly also on the regions of the fourth insulating layer 112 that are exposed by the gate window 114), the removal of the mask and the metal deposition present thereon is performed and finally a thermal annealing is performed (for example at about 560°C) . In detail, if the mask used for the metal deposition exposes only the gate window 114, the gate region 74 will be aligned with the gate window 114 and therefore comprise only the surface portion 74A, while if the mask used for the metal deposition also exposes regions of the fourth insulating layer 112 which are contiguous to the gate window 114, the gate region 74 will also extend outside the gate window 114 on the fourth insulating layer 112 and therefore comprise both the surface portion 74A and the upper portion 74B.

Further manufacturing steps of the HEMT device 50 may then follow, not shown and not described herein as they are known (e.g., the formation of metallizations, etc.).

From an examination of the characteristics of the invention made according to the present invention, the advantages that it affords are evident.

In particular, the previously described manufacturing process allows the manufacturing of D-mode HEMTs and E-mode HEMTs with pGaN-gate structure to be integrated, making these two solutions monolithic and therefore reducing their complexity and manufacturing costs.

In fact, the dielectric protection layer 67 prevents the chemical etching of Figure 2I performed to form the gate region 74 from damaging the surface 66A of the barrier layer 66, introducing traps for the charge carriers of the barrier layer 66 and causing a resulting degradation of the electrical performance of the HEMT device 50. However, the reduced thickness of the dielectric protection layer 67 does not make the manufacturing of the HEMT device 50 of D-mode type incompatible with the manufacturing of the known E-mode HEMTs.

In detail, the presence of the dielectric protection layer 67 during the chemical etching of Figure 2I allows the threshold voltage of the HEMT device 50 to be stabilized, the gate leakage current in reverse bias condition to be reduced and the on-resistance to be reduced. Furthermore, the thickness of the dielectric protection layer 67 modifies the pinch-off voltage and therefore this parameter may be varied during the design step on the basis of the dielectric protection layer 67. In greater detail, the drain leakage current for gate voltages lower than the pinch-off voltage, as well as the same pinch-off voltage, decrease as the thickness of the dielectric protection layer 67 increases.

In greater detail, it has been verified that these advantages are achieved even when the dielectric protection layer 67 covers the sole region of the barrier layer 66 which is placed at the gate region 74 (e.g., it is vertically aligned with the latter).

In particular, the HEMT device 50 is particularly suitable for working at low powers, i.e. with drain voltage values generally lower than, or equal to, about 12 V. This further simplifies the structure of the HEMT device 50, since in this case the field plate may for example be absent.

Finally, it is clear that modifications and variations may be made to the invention described and illustrated herein without thereby departing from the scope of the present invention, as defined in the attached claims.

For example, the different embodiments described may be combined with each other to provide further solutions.

Furthermore, although Figures 2A-2J refer to the manufacturing of the HEMT device 50 of a depletion mode, the process described herein is compatible with the simultaneous manufacturing, starting from the same work body 100, of at least one further HEMT device (also referred to as second device HEMT), in particular of an enrichment mode and for example with a pGaN-type gate structure.

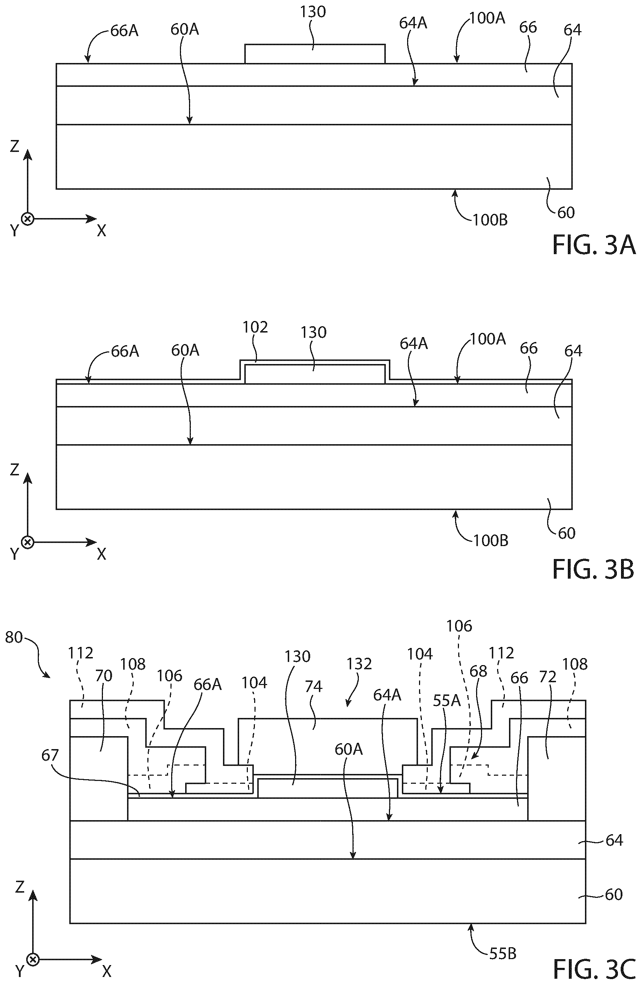

Figure 3C shows an HEMT device 80 of an enrichment mode, obtained through the previously described manufacturing process and starting from the same work body 100 used for manufacturing the HEMT device 50. Accordingly, the HEMT device 80 and the HEMT device 50 are integral with each other and define a monolithic solution.

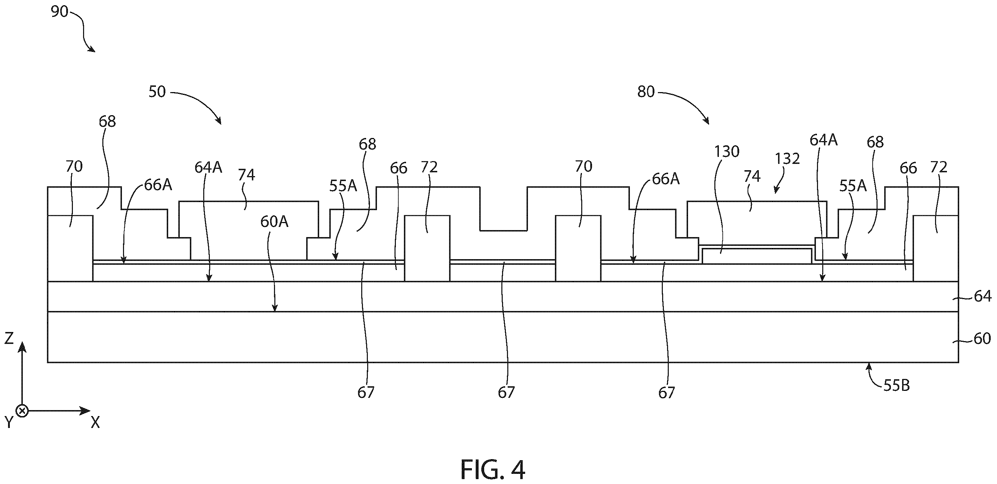

In particular, the HEMT device 80 and the HEMT device 50 are comprised in an electronic assembly (shown in Figure 4 with the reference 90), in detail of a monolithic type and formed starting from the work body 100 in such a way that the HEMT device 80 and the HEMT device 50 share the substrate 60 and the heterostructure 62.

As exemplarily shown in Figure 4, the HEMT device 50 of a depletion mode and the HEMT device 80 of an enrichment mode may be lateral to each other, for example they are arranged side by side to each other along the X axis.

In particular, the HEMT device 80 has a pGaN-type gate structure.

As shown with reference to Figures 3A-3C, the manufacturing of the HEMT device 80 occurs by performing the same manufacturing steps previously described, with the addition of the localized formation on the barrier layer 66 of Figure 2A of a channel modulation region which is of pGaN (gallium nitride with P-type conductivity due for example to doping with magnesium), before forming the dielectric layer 102.

This channel modulation region (shown in Figure 3A with the reference 130) will be part of the gate structure 132 of the HEMT device 80, together with the gate region 74.

In detail, after performing the steps previously described in Figure 2A, the channel modulation region 130 is formed (Figure 3A) on the surface 66A of the barrier layer 66.

In greater detail, this occurs by depositing a pGaN layer (not shown and for example with a thickness comprised between about 30 nm and about 150 nm) in a uniform manner on the surface 66A of the barrier layer 66. Thereafter, a chemical etching is performed on the pGaN layer in such a way as to leave a part thereof placed at where the gate structure of the HEMT device 80 will be formed and which will therefore form the channel modulation region 130, instead removing the remaining part of the pGaN layer which will not be part of the gate structure of the HEMT device 80. In detail, this occurs by forming, on the pGaN layer, a mask which covers the part of the pGaN layer intended to form the channel modulation region 130 and which leaves the remaining parts of the pGaN layer exposed, performing an etching through known techniques through the mask in order to remove the parts of the pGaN layer that will not be part of the gate structure, and finally removing the mask to obtain the structure shown in Figure 3A.

Subsequently, Figure 3B, the dielectric layer 102 is formed both on the channel modulation region 130 and on the regions of the barrier layer 66 exposed by the channel modulation region 130, in a manner similar to what has been previously described.

In the embodiment considered here, the dielectric layer 102 defines the dielectric protection layer 67.

Nonetheless and similarly to what has been previously described, further steps may be performed to form the dielectric protection layer 67 starting from the dielectric layer 102. For example, in case the dielectric protection layer 67 extends only under the gate region 74 of the HEMT device 50, the formation of the dielectric layer 102 is followed by an etching that selectively removes the portions of the dielectric layer 102 that are not intended to be vertically aligned with the gate region 74 of the HEMT device 50, leaving instead the portion of the dielectric layer 102 which is intended to be vertically aligned with the gate region 74 of the HEMT device 50 and which therefore forms the dielectric protection layer 67.

Similarly, this chemical etching may be used to remove only the part of the dielectric layer 102 that extends over the channel modulation region 130, if it is desired to have a Schottky contact between the channel modulation region 130 and the gate region 74 of the HEMT device 80.

Returning to the embodiment of Figure 3B, steps similar to those previously described with reference to Figures 2C-2J and therefore not described in detail then follow, which lead to the structure of the HEMT device 80 shown in Figure 3C.

## Claims

1. An HEMT device (50) comprising:
a heterostructure (62) comprising a channel layer (64) and a barrier layer (66) extending, along a first axis (Z), onto the channel layer (64);
a dielectric protection layer (67) of dielectric material, extending along the first axis (Z) onto the barrier layer (66); and
a gate region (74) extending along the first axis (Z) onto the dielectric protection layer (67),
wherein the dielectric protection layer (67) has, along the first axis (Z), a thickness (t_{d}) lower than 10 nm.

2. The HEMT device according to claim 1, wherein the thickness (t_{d}) of the dielectric protection layer (67) is comprised between 1 nm and 7 nm.

3. The HEMT device according to claim 1 or 2, wherein the dielectric protection layer (67) is of one of the following materials: aluminum oxide, silicon oxide, silicon nitride and aluminum nitride.

4. The HEMT device according to any of the preceding claims, wherein the channel layer (64) is of gallium nitride or of a gallium-nitride-based alloy and the barrier layer (66) is of a gallium-nitride-based alloy, in particular is of AlGaN.

5. The HEMT device according to any of the preceding claims, wherein the dielectric protection layer (67) is directly interposed along the first axis (Z) between the barrier layer (66) and the gate region (74).

6. The HEMT device according to any of the preceding claims, wherein the HEMT device (50) is of a depletion mode.

7. The HEMT device according to any of the preceding claims, wherein the gate region (74) and the dielectric protection layer (67) form an insulated-type gate structure of the HEMT device (50).

8. An electronic assembly (90) comprising a HEMT device (50), according to any of the preceding claims and of a depletion mode, and a further HEMT device (80), of an enrichment mode, which are integral with each other.

9. The electronic assembly (90) according to claim 8, wherein the further HEMT device (80) has a pGaN-type gate structure.

10. A process of manufacturing a HEMT device (50) including a heterostructure (62) comprising a channel layer (64) and a barrier layer (66) extending, along a first axis (Z), onto the channel layer (64), the manufacturing process comprising the steps of:
- forming, on the barrier layer (66), a dielectric protection layer (67) of dielectric material; and
- forming, on the dielectric protection layer (67), a gate region (74),
wherein the dielectric protection layer (67) has, along the first axis (Z), a thickness (t_{d}) lower than 10 nm.

11. The manufacturing process according to claim 10, further comprising the steps of:
- forming, on the dielectric protection layer (67), a plurality of insulating layers (104, 106, 108, 112); and
- forming a gate window (114) through the insulating layers (104, 106, 108, 112) in such a way as to at least partially expose the dielectric protection layer (67),
wherein the step of forming the gate region (74) occurs through the gate window (114).

12. The manufacturing process according to claim 11, wherein the step of forming the gate window (114) comprises performing one or more chemical etchings configured to selectively remove at least one part of the insulating layers (104, 106, 108, 112) without removing the dielectric protection layer (67).

13. The manufacturing process according to claim 12, wherein the step of forming the insulating layers (104, 106, 108, 112) comprises:
- forming, on the dielectric protection layer (67), a first insulating layer (104) of said insulating layers (104, 106, 108, 112), of insulating material;
- forming in succession, on the first insulating layer (104), a second (106) and a third (108) insulating layer of said insulating layers (104, 106, 108, 112), of passivating material;
- forming a work window (110) through the second (106) and the third (108) insulating layers in such a way as to at least partially expose the first insulating layer (104); and
- forming, through the work window (110) and on the first exposed insulating layer (104), a fourth insulating layer (112) of said insulating layers (104, 106, 108, 112), of insulating material,
wherein the step of forming the gate window (114) comprises performing said one or more chemical etchings configured to selectively remove the fourth (112) and the first (104) insulating layers in such a way as to at least partially expose the dielectric protection layer (67).

14. The manufacturing process according to claim 13, further comprising, between the step of forming the second insulating layer (106) and the step of forming the third insulating layer (108), the step of forming a source region (70) and a drain region (72) of the HEMT device (50) through the second insulating layer (106) and the barrier layer (66), and
wherein the step of forming the third insulating layer (108) comprises forming the third insulating layer (108) on the second insulating layer (106), the source region (70), and the drain region (72).

15. The manufacturing process according to any of claims 10-14, further comprising, before the step of forming the dielectric protection layer (67), the step of forming locally on the barrier layer (66) a channel modulation region (130) of pGaN, the channel modulation region (130) being configured to be comprised in a gate structure (132) of a further HEMT device (80) lateral to the HEMT device (50), and
wherein the step of forming the dielectric protection layer (67) comprises forming the dielectric protection layer (67) on the channel modulation region (130) and on the barrier layer (66) exposed by the channel modulation region (130) .
